Europäisches Patentamt

European Patent Office

Office européen des brevets

(11) Veröffentlichungsnummer: **0 307 593**
**A2**

(12) # EUROPÄISCHE PATENTANMELDUNG

(21) Anmeldenummer: 88112179.2

(22) Anmeldetag: 28.07.88

(51) Int. Cl.⁴: **H05K 7/12**

(30) Priorität: 09.09.87 DE 3730203

(43) Veröffentlichungstag der Anmeldung:
22.03.89 Patentblatt 89/12

(84) Benannte Vertragsstaaten:
DE FR GB IT

(71) Anmelder: **ROBERT BOSCH GMBH**
**Postfach 10 60 50**
**D-7000 Stuttgart 10(DE)**

(72) Erfinder: **Kaiser, Harry, Dipl.-Ing.**
**Am Mühlberg 20**
**D-7145 Markgröningen(DE)**

(54) **Lagesicherungselement für Bauteile.**

(57) Das Lagesicherungselement (4) befindet sich an einem ersten Bauteil (2) und dient zur Lagesicherung eines zweiten Bauteils (5), das in vorbestimmter Ausrichtung mit dem ersten Bauteil (2) zu vereinigen ist. Das Lagesicherungselement (4) hat im wesentlichen die Form einer Nase, die sich über eine Bezugsebene des ersten Bauteils (2) erhebt. Das Lagesicherungselement (4) wird hergestellt mittels eines dornähnlichen Werkzeugs, das zur Bezugsebene geneigt in das erste Bauteil (2) eingepreßt wird. Dabei wird Werkstoff verschoben, so daß sich einerseits eine nutartige Vertiefung (8) und andererseits oberhalb der Bezugsebene eine Werkstoffanhäufung bildet mit einer Form, die der des Lagesicherungselements (4) entspricht. Das Lagesicherungselement (4) ist geeignet zur Lagesicherung von beispielsweise elektrischen Schaltungen oder anderen Bauteilen beim Aufkleben oder Auflöten auf das erste Bauteil (2).

Fig. 1

EP 0 307 593 A2

## Lagesicherungselement für Bauteile

### Stand der Technik

Die Erfindung geht aus von einem Lagesicherungselement nach der Gattung des Anspruchs 1 oder einem Verfahren zur Herstellung eines Lagesicherungselements nach der Gattung des Anspruchs 4. Die DE-OS 35 16 489 offenbart ein erstes in seinem mittleren Bereich plattenartig ausgebildetes Bauteil mit Lagesicherungselementen zur Lagesicherung von zweiten Bauteilen relativ zu dem ersten Bauteil. Die Lagesicherungselemente sind in Form von zylindrischen Noppen ausgebildet, die über eine Bezugsebene des ersten Bauteils emporragen. Die Noppen können beispielsweise in Löcher eingreifen, die sich in den zweiten Bauteilen befinden. Die zweiten Bauteile können beispielsweise Leistungshalbleiter oder andere elektrische Schaltungen sein. Hergestellt werden diese Noppen mittels eines Werkzeugs, das ähnlich einem Stanzstempel ausgebildet sein kann und in die Rückseite des ersten Bauteils eingedrückt wird. Zur Vermeidung von Bruch des Stempels sollte dessen Durchmesser möglichst größer sein als die Dicke des ersten Bauteils. Dies hat den Nachteil, daß bei großer Dicke des ersten Bauteils sehr große Kräfte zum Eindrücken des Werkzeugs nötig sind. Des weiteren besteht in denjenigen Fällen, in denen das zweite Bauteil kein Zentrierloch besitzt und deshalb zwischen mehrere Noppen einzusetzen ist, der Nachteil, daß wegen des großen Platzbedarfs der Noppen deren Unterbringung schwierig ist oder gar zur nachteiligen Vergrößerung des ersten Bauteils und damit des gesamten Geräts führt.

### Vorteile der Erfindung

Das Lagesicherungselement mit den kennzeichnenden Merkmalen des Anspruchs 1 hat den Vorteil, daß es raumsparend klein ausbildbar ist, gleichgültig wie dick das erste Bauteil aus konstruktiven Gründen, beispielsweise weil es eine Grundplatte eines Meßgerätes bildet oder große Wärmemengen abzuleiten hat, gestaltet ist. Die kennzeichnenden Merkmale des Anspruchs 4 ermöglichen eine wirtschaftliche Herstellung des Lagesicherungselements und vermindern die Gefahr von Werkzeugbruch.

Die kennzeichnenden Merkmale der Ansprüche 2 und 3 geben konkrete Ausführungsbeispiele an, die mittels einfach ausbildbarer Werkzeuge herstellbar sind. Dabei sind diese Werkzeuge in einfacher Weise so ausbildbar, daß ein Werkzeugbruch nicht zu befürchten ist.

### Zeichnung

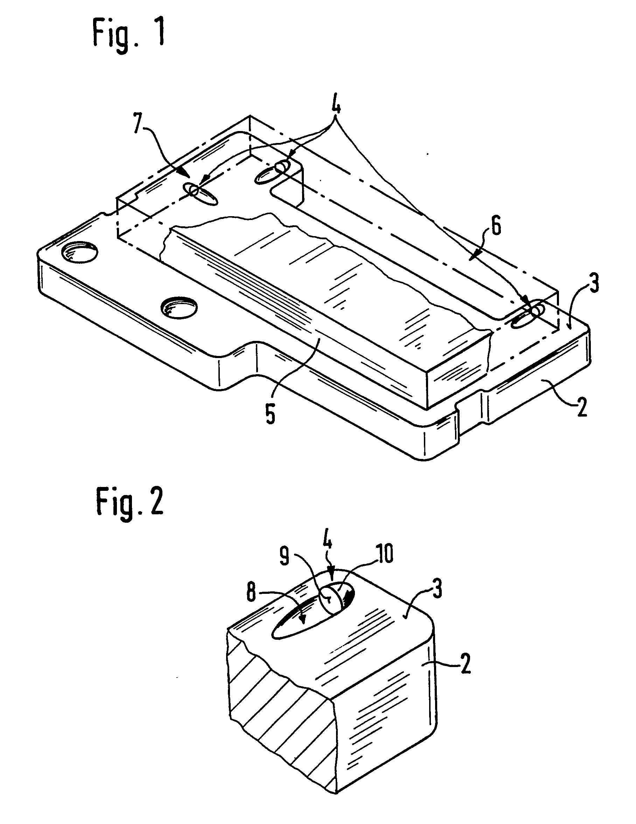

Ein Ausführungsbeispiel des erfindungsgemäßen Lagesicherungselements ist in der Zeichnung dargestellt und nachfolgend näher erläutert. Es zeigen Figur 1 ein erstes Bauteil mit Lagesicherungselementen der erfindungsgemäßen Art in schrägbildlicher Darstellung und Figur 2 eines dieser Lagesicherungselemente in vergrößerter Darstellung.

### Beschreibung des Ausführungsbeispiels

Ein erstes Bauteil 2 hat in Figur 1 eine ebenflächig ausgebildete Oberfläche 3, die in einer gedachten Bezugsebene liegt. Das dargestellte erste Bauteil 2 ist relativ dick ausgebildet und besitzt beispielsweise drei erfindungsgemäße Lagesicherungselemente 4. Diese vier Lagesicherungselemente 4 dienen zur Lagesicherung eines zweiten Bauteils 5, das wenigstens zwei Anschlagflächen 6 und 7 besitzt. Das zweite Bauteile 5 kann beispielsweise ein in der DE-OS 35 16 489 erwähnter Leistungshalbleiter oder aber eine Platine mit diskreten und/oder integrierten Schaltungsbestandteilen sein. Das zweite Bauteil 5 kann aber auch irgendein Bauteil sein, das zur Elektrik oder Elektronik keinen Bezug besitzt.

Das in der Figur 2 vergrößert dargestellte Lagesicherungselement 4 besteht aus einer Anhäufung aus demjenigen Werkstoff, aus dem das erste Bauteil 2 besteht. Diese Anhäufung ist erzeugbar unter Verwendung eines dornähnlichen oder eines nutmeißelähnlichen Werkzeugs, das auf einer beispielsweise zur Oberfläche 3 geneigten Bewegungsbahn geführt und in das erste Bauteil 2 eingedrückt wird. Dabei entsteht eine nutartige Vertiefung 8. Das aus dieser nutartigen Vertiefung 8 unterhalb der über die Oberfläche 3 des ersten Bauteils 2 gelegten Bezugsebene entnommene Volumen von Werkstoff ist in Bewegungsrichtung des Werkzeugs verschoben und ragt nunmehr als ein im wesentlichen nasenförmiges Lagesicherungselement 4 über die genannte Bezugsebene empor. Das Lagesicherungselement 4 hat dabei die Beschaffenheit eines stehen gebliebenen Spanes. Dort, wo das Werkzeug angegriffen hat, besitzt das Lagesicherungselement 4 eine Begrenzungsfläche 9. In dem in der Figur 1 dargestellten Ausführungsbeispiel dient derjenige Teil der Begrenzungsfläche 9, der über die erwähnte Bezugsebene emporragt, als Anschlagfläche für die Anschlagflächen 6 und 7 des zweiten Bauteils.

Auch wenn, wie erwähnt, das Lagesicherungselement im wesentlichen nasenförmig ausgebildet ist, ist es nicht notwendig, daß die Begrenzungsfläche 9 zur Lagesicherung von einem zweiten Bauteil 5 verwendet wird. Vielmehr kann auch irgendeine andere ausreichend steil gegenüber der Oberfläche 3 emporragende Fläche 10 zur Lage sicherung von irgendwelchen Bauteilen verwendet werden. Bei entsprechender Formgestaltung des jeweils verwendeten Werkzeugs ergeben sich nasenförmige Lagesicherungselemente, die in ausreichendem Maß geeignet sind, beispielsweise die durch die DE-OS 35 16 489 vor bekannten zylindrischen Noppen zu ersetzen. Dies ist beispielsweise dann möglich, wenn das zweite Bauteil 5 durch andere Befestigungsmittel ausreichend am ersten Bauteil 2 gesichert wird. Dies kann beispielsweise durch Anordnen einer Klebverbindung oder einer Lötverbindung zwischen den beiden Bauteilen 2 und 5 erreicht werden. Es ist also erkennbar, daß die Lagesicherungselemente 4 beispielsweise als Hilfsmittel zum Ausrichten von Bauteilen während deren Vereinigung nutzbar sind. Weil hierbei wenig Kräfte zur Lagesicherung schon ausreichen, wird die Festigkeit von auch relativ klein ausgebildeten nasenförmigen Lagesicherungselementen 4 der erfindungsgemäßen Art völlig ausreichend sein. Zur Herstellung dieser Lagesicherungselemente sind natürlich solche Werkstoffe gut geeignet, die beispielsweise zur Herstellung von Fließpreßteilen besonders geeignet sind. Für den Fall, daß das die Lagesicherungselemente 4 aufweisende erste Bauteil aus Aluminium bestehen soll, bietet sich demnach die Herstellung aus einer sogenannten Knetlegierung an.

**Ansprüche**

1. Lagesicherungselement, das sich über eine Bezugsebene, in der eine Oberfläche eines ersten Bauteils liegt, erhebt und aus dem gleichen Werkstoff wie das erste Bauteil besteht und der Lagesicherung eines zweiten Bauteils dient, das in Anlage zu der Oberfläche des ersten Bauteils an diesem zu fixieren ist, dadurch gekennzeichnet, daß das Lagesicherungselement (4) die Form eines Raspelzahnes hat und aus einer Werkstoffmenge besteht, die aus einer unmittelbar neben dem Lagesicherungselement unter der Bezugsebene der Oberfläche liegenden nutartigen Vertiefung (8) stammt.

2. Lagesicherungselement nach Anspruch 1, dadurch gekennzeichnet, daß die Werkstoffanhäufung ein spanartiges Gebilde ist, das mittels eines dornähnlichen Werkzeugs geformt ist.

3. Lagesicherungselement nach Anspruch 1, dadurch gekennzeichnet, daß die Werkstoffanhäufung ein spanartiges Gebilde ist, das mittels eines nach Art eines Nutmeißels ausgebildeten Werkzeugs herstellbar ist.

4. Verfahren zum Herstellen eines Lagesicherungselements, das sich über eine Bezugsebene erhebt, in der eine Oberfläche des Bauteils liegt, und aus dem gleichen Werkstoff wie dieses Bauteil besteht, dadurch gekennzeichnet, daß die das Lagesicherungselement bilden die Werkstoffmenge angehäuft wird durch Verschieben von unmittelbar an diese Bezugsebene angrenzenden Werkstoff mittels eines durch diese Bezugsebene hindurch bewegbaren Werkzeugs, das dabei in diesem Bauteil neben dem Lagesicherungselement eine nutartige Vertiefung erzeugt.

EP 0 307 593 A2

# Fig. 1

# Fig. 2